# EUROPÄISCHE PATENTSCHRIFT

(11) **EP 1 794 816 B1**
(45) Veröffentlichungstag und Bekanntmachung des Hinweises auf die Patenterteilung: **04.11.2015**
(21) Anmeldenummer: 05791446.7
(22) Anmeldetag: 23.09.2005
(51) Int. Cl.: H01L 33/00

(54) **Verfahren zur Herstellung eines Dünnfilmhalbleiterchips**
Method of producing a thin-film semiconductor chip
Procédé pour fabriquer une puce semi-conductrice à couche mince

(30) Priorität: 29.09.2004 DE 102004047392; 22.12.2004 DE 102004061865
(43) Veröffentlichungstag der Anmeldung: 13.06.2007
(73) Patentinhaber: OSRAM Opto Semiconductors GmbH, 93055 Regensburg (DE)
(72) Erfinder: PLÖSSL, Andreas, 93051 Regensburg (DE); STEIN, Wilhelm, 88131 Lindau (DE)
(74) Vertreter: Epping - Hermann - Fischer
(86) Internationale Anmeldenummer: PCT/DE2005/001684
(87) Internationale Veröffentlichungsnummer: WO 2006/034686

(56) Entgegenhaltungen:
- EP-A- 1 306 899
- DE-A1- 10 307 280
- US-A- 4 044 222
- US-A- 4 142 160
- US-A- 4 307 131
- US-A1- 2003 111 667
- US-A1- 2003 170 971
- BER B Y ET AL: "LASER FORMATION OF OHMIC CONTACTS TO N-TYPE GALLIUM ARSENIDE" SOVIET TECHNICAL PHYSICS LETTERS, AMERICAN INSTITUTE OF PHYSICS. NEW YORK, US, Bd. 17, Nr. 10, 1. Oktober 1991 (1991-10-01), Seiten 745-747, XP000273628

## Beschreibung

Die Erfindung betrifft ein Verfahren zur Herstellung eines Dünnfilmhalbleiterchips.

Dünnfilmhalbleiterchips sind beispielsweise aus der Druckschrift EP 0 905 797 A2 bekannt. Zur Herstellung derartiger Dünnfilmhalbleiterchips wird eine aktive Schichtenfolge auf Basis eines III/V-Verbindungshalbleitermaterials, die geeignet ist, elektromagnetische Strahlung zu emittieren, auf einem Aufwachssubstrat aufgebracht. Da ein auf das III/V-Verbindungshalbleitermaterial abgestimmtes Aufwachssubstrat meist einen Teil der von der aktiven Schichtenfolge erzeugten elektromagnetischen Strahlung absorbiert, wird zur Erhöhung der Lichtausbeute die aktive Schichtenfolge vom Aufwachssubstrat getrennt und auf einen anderen Träger aufgebracht. Die Verbindung zwischen aktiver Schichtenfolge und Träger wird durch Kleben oder Löten hergestellt.

Zwischen dem Träger und der aktiven Schichtenfolge befindet sich eine reflektierende Schichtenfolge. Die reflektierende Schichtenfolge hat die Aufgabe, elektromagnetische Strahlung zur Strahlung emittierenden Vorderseite des Dünnfilmhalbleiterchips zu lenken und so die Strahlungsausbeute des Chips zu erhöhen. In der Regel umfasst die reflektierende Schichtenfolge mindestens eine dielektrische Schicht.

Wie beispielsweise in der Druckschrift DE 10 2004 004 780 A1 beschrieben, wird zur rückseitigen elektrischen Kontaktierung der aktiven Schichtenfolge die dielektrische Schicht photolithographisch strukturiert, so dass Öffnungen in der dielektrischen Schicht zur Rückseite der aktiven Schichtenfolge entstehen. Nachfolgend wird eine Metallschicht aufgebracht, die die Öffnungen füllt und miteinander verbindet, so dass die aktive Schichtenfolge rückseitige Kontaktstellen aufweist, die miteinander elektrisch leitend verbunden sind. Die metallische Schicht enthält beispielsweise im Wesentlichen Au und mindestens einen Dotierstoff wie beispielsweise Zn. Durch Tempern der metallischen Schicht wird ein Eindiffundieren des Dotierstoffes in das III/V-Verbindungshalbleitermaterial bewirkt. Bei geeigneter Wahl des Dotierstoffes werden so vermehrt Ladungsträger im III/V-Verbindungshalbleitermaterial an der Grenzfläche zur metallischen Schicht erzeugt, was zu einer elektrischen Kontaktstelle mit im Wesentlichen ohmscher Charakteristik führt.

In der Druckschrift DE 10307 208 A1 ist ein weiteres Verfahren beschrieben, bei dem ein Dünnfilmhalbleiterchip durch die Trennung der aktiven Schichtenfolge vom Aufwachssubstrat hergestellt wird.

In der Druckschrift DE 10046 170 A1 ist weiterhin ein Verfahren beschrieben bei dem mit Hilfe eines Lasers elektrische leitfähige Kontaktstellen einer Solarzelle durch eine passivierende Schicht erzeugt werden.

Aufgabe der vorliegenden Erfindung ist es, ein vereinfachtes Verfahren zur Herstellung eines Dünnfilmhalbleiterchips und insbesondere der elektrisch leitfähigen Kontaktstellen der aktiven Schichtenfolge anzugeben.

Diese Aufgabe wird durch ein Verfahren mit den Schritten gemäß Patentanspruch 1 gelöst.

Weitere Ausgestaltungen und Weiterbildungen der Erfindung ergeben sich aus den abhängigen Ansprüchen 2 bis 9. Ein Verfahren zur Herstellung eines Dünnfilmhalbleiterchips basierend auf einem III/V-Verbindungshalbleitermaterial, der geeignet ist, elektromagnetische Strahlung zu erzeugen, umfasst die in Anspruch 1 aufgeführten Schritte.

Die reflektierende Schichtenfolge zwischen aktiver Schichtenfolge und Träger umfasst mindestens eine dielektrische und eine metallische Schicht, wobei die dielektrische Schicht beispielsweise SiNₓ und die metallische Schicht beispielsweise Au und Zn enthält. Weiterhin kann die dielektrische Schicht auch Phosphosilikatglas umfassen, wobei eine solche dielektrische Schicht mit Phosphosilikatglas bevorzugt von einer weiteren Verkapselungsschicht, die beispielsweise Siliziumnitrid umfasst, gekapselt wird, um weitestgehend zu verhindern dass Feuchtigkeit an die Phosphosilikatglasschicht gelangt und sich Phosphorsäure bildet. Ein solches reflektierendes Schichtsystem zur Aufbringung auf ein III/V-Verbindungshalbleitermaterial ist beispielsweise in der Druckschrift DE 10 2004 040 277 A1 beschrieben.

Da die reflektierende Schichtenfolge mindestens eine dielektrische Schicht umfasst, muss zur rückseitigen elektrischen Kontaktierung der aktiven Schichtenfolge mindestens eine Kontaktstelle durch die reflektierende Schichtenfolge hindurch zur Rückseite der aktiven Schichtenfolge hin ausgebildet werden.

Gemäß dem Verfahren wird die Öffnung innerhalb der dielektrischen Schicht zur Rückseite der aktiven Schichtenfolge hin, innerhalb der nachfolgend eine elektrisch leitfähige Kontaktstelle ausgebildet wird, mit Hilfe eines Lasers geschaffen.

Dies bietet den Vorteil, dass photolithographische Prozesse, die in der Regel zeit- und kostenintensiv sind, bei der Herstellung des Dünnfilmhalbleiterchips reduziert werden können. Weiterhin sind bei diesem Verfahren vorteilhafterweise Kontaktstellen mit sehr geringem Querschnitt möglich, da mit einem Laser kleinere Strukturierungen geschaffen werden können, als mit photolithographischen Methoden.

Das reflektierende Schichtsystem kann neben der dielektrischen Schicht und der metallischen Schicht auch weitere Schichten umfassen. Es kann sich hierbei beispielsweise um Schichten zur Kapselung der dielektrischen oder der metallischen Schicht oder um Schichten zur Haftvermittlung zwischen einzelnen Schichten der reflektierenden Schichtenfolge handeln. Auch durch diese Schichten hindurch können in der Regel Öffnungen mit Hilfe eines Lasers geschaffen werden und eine elektrische Kontaktstelle innerhalb dieser Öffnungen zur Rückseite der aktiven Schichtenfolge ausgebildet werden.

Bei einer bevorzugten Ausführungsform des Verfahrens wird die rückseitige Kontaktstelle in einem nachfolgenden Schritt getempert. Durch das Tempern der elektrisch leitfähigen Kontaktstelle können Atome aus dem metallischen Material der Kontaktstelle in das rückseitige III/V-Verbindungshalbleitermaterial eindiffundieren. Bei geeigneter Wahl des metallischen Materials unter Berücksichtigung des rückseitigen III/V-Verbindungshalbleitermaterials kann so eine elektrisch leitfähige Kontaktstelle zum rückseitigen I-II/V-Verbindungshalbleitermaterial mit im wesentlichen ohmscher Charakteristik hergestellt werden.

Besonders bevorzugt wird die rückseitige elektrisch leitfähige Kontaktstelle mit Hilfe eines Lasers getempert.

Mit Hilfe eines Lasers ist es möglich Energie gezielt nur in begrenzte Volumenbereiche des Dünnfilmhalbleiterchips einzubringen. Insbesondere kann die Energie im Bereich des elektrisch leitfähigen Kontaktes im Bereich der Grenzfläche zum III/V-Verbindungshalbleitermaterial lokal eingebracht werden. Ein Verfahren zur Oberflächenbehandlung mit Hilfe eines Lasers ist in der Druckschrift DE 10141352.1 beschrieben, deren Offenbarungsgehalt insofern hiermit durch Rückbezug aufgenommen wird. Diese Ausführungsform des Verfahrens bietet den Vorteil, dass zur Ausbildung einer elektrischen Kontaktstelle mit im Wesentlichen ohmscher Charakteristik lokal stark begrenzt nur die Bereiche des Chips erhöhten Temperaturen ausgesetzt werden, bei denen dies notwendig ist.

Dadurch wird vorteilhafterweise verhindert, dass beim Tempern auch andere Bereiche des Halbleiterchips erhöhten Temperaturen ausgesetzt werden und so Metallatome auch in Bereiche diffundieren, in denen sie unerwünscht sind.

Umfasst die metallische Schicht der reflektierenden Schichtenfolge, beispielsweise verschiedene Sorten von Metallen, von denen eines schlechtere reflektierende Eigenschaften als dass andere aufweist und trennen sich diese beiden Metalle beim Temperprozess auf Grund unterschiedlicher diffusiver Eigenschaften, können sich Metallatome mit schlechteren reflektierenden Eigenschaften lokal akkumulieren und so die Reflektivität der reflektierenden Schichtenfolge vermindern. Als Beispiel hierfür sei eine reflektierende Schichtenfolge auf einem p-dotierten III/V-Verbindungshalbleitermaterial betrachtet, die eine dielektrische Schicht und eine metallische Schicht umfasst, wobei die metallische Schicht Au und Zn enthält. Au weist sehr gute Reflektivitäten für elektromagnetische Strahlung im roten Spektralbereich des sichtbaren Lichtes auf. Zn hingegen ist gut geeignet beim Tempern in den p-dotierten III-V-Verbindungshalbleiter zu diffundieren und dadurch der elektrisch leitfähigen Kontaktstelle eine weitestgehend ohmsche Charakteristik zu verleihen. Werden nun Bereiche der reflektierenden Schichtenfolge erhöhten Temperaturen ausgesetzt, können die Zn-Atome auch an die Grenzfläche zur dielektrischen Schicht wandern. Da Zn gegenüber Au jedoch verminderte Reflektivitäten vor allem für elektromagnetische Strahlung mit Wellenlängen im roten Bereich des sichtbaren Lichtes aufweist, wird die Güte der reflektierenden Schichtenfolge für rotes Licht hierdurch vermindert.

Weiterhin können Metallatome bei nicht-lokalen Temperpozessen auch in die aktive Schichtenfolge diffundieren. Dort stellen sie in der Regel Störstellen dar, die nicht-strahlende Rekombination von Photonen fördern und mindern so die Effizienz des Dünnfilmhalbleiterchips. Um dies zu vermeiden, befindet sich in der Regel auf der aktiven Schichtenfolge eine hinreichend dicke Schicht an nicht aktivem III/V-Verbindungshalbleitermaterial. Wird der Kontakt erfindungsgemäß lokal mit einem Laser getempert, kann die Dicke dieses nicht aktiven III/V-Verbindungshalbleitermaterials und damit die Dicke des Dünnfilmhalbleiterchips vorteilhafterweise verringert werden.

Bei einer bevorzugten Ausführungsform des Verfahrens wird auf die Vorderseite der aktiven Schichtenfolge eine vergütende Schichtenfolge aufgebracht, die mindestens eine dielektrische Schicht umfasst. Nachfolgend wird, zumindest teilweise, mindestens eine metallische Schicht auf die vergütende Schichtenfolge aufgebracht und Energie mit Hilfe eines Lasers in definiert begrenzte Volumenbereiche der vergütenden Schichtenfolge und der metallischen Schicht eingebracht, so dass mindestens eine vorderseitige elektrisch leitfähige Kontaktstelle zur Vorderseite der aktiven Schichtenfolge ausgebildet wird.

Die vergütende Schichtenfolge kann beispielsweise eine dielektrische Schicht enthalten, die Glas umfasst und so strukturiert ist, dass die Auskopplung von elektromagnetischer Strahlung an der Vorderseite des Dünnfilmhalbleiterchips verbessert wird. Weiterhin kann eine vergütende Schichtenfolge zusätzlich oder ausschließlich schützende und passivierende Funktion haben.

Die Ausbildung von vorderseitigen Kontaktstellen durch eine vergütende Schichtenfolge, die mindestens eine dielektrische Schicht enthält, zur Vorderseite der aktiven Schichtenfolge erfolgt durch eine reflektierende Schichtenfolge, die eine dielektrische Schicht enthält. Durch das Einbringen von Energie in definiert begrenzte Volumenbereiche der metallischen Schicht und der vergütenden Schichtenfolge mit Hilfe eines Lasers, wird wiederum die dielektrische Schicht lokal zersetzt oder aufgeschmolzen oder beides und das lokal geschmolzene Material der metallischen Schicht stellt eine elektrisch leitfähige Kontaktstelle zur Vorderseite der aktiven Schichtenfolge her. Die Ausbildung vorderseitiger Kontaktstellen mit Hilfe eines Lasers bietet die selben Vorteile wie die oben beschriebenen Vorteile bei der Ausbildung rückseitiger Kontakte mit Hilfe eines Lasers. Außerdem stellt sich bei herkömmlichen Temper-Prozessen zum Tempern vorderseitiger Kontakte bei denen nicht nur lokal begrenzte Volumenbereiche des Halbleiterchips erhöhten Temperaturen ausgesetzt wird, sondern beispielsweise der ganze Chip, das Problem, dass die Temperaturbeständigkeit der Fügematerialien zwischen aktiver Schichtenfolge und Träger die Temperatur zum Tempern begrenzt. Deshalb werden die Chips bei herkömmlichen nicht-lokalen Temper-Prozessen in der Regel mit geringeren Temperaturen beaufschlagt als für die Kontaktbildung wünschenswert wäre. Dieses Problem kann vorteilhafterweise umgangen werden, wenn der Kontakt nicht nachträglich getempert werden muss.

Befindet sich eine dielektrische Schicht beispielsweise als Teil einer vergütenden Schichtenfolge auf der Vorderseite der aktiven Schichtenfolge, so kann weiterhin eine vorderseitige Kontaktstelle durch die vergütende Schichtenfolge hindurch ausgebildet werden, indem mindestens eine Öffnung durch die vergütende Schichtenfolge mit Hilfe eines Lasers geschaffen wird. Auf diese wird, wie bei dem Verfahren gemäß Patentanspruch 1, nachfolgend eine metallische Schicht aufgebracht, die die Öffnung mit metallischem Material füllt und so eine elektrisch leitfähige Kontaktstellen zur Vorderseite der aktiven Schichtenfolge herstellt.

Weiterhin kann bei beiden Verfahren auch erst mindestens eine elektrisch leitfähige Kontaktstelle auf der Vorderseite der aktiven Schichtenfolge aufgebracht werden, die nachfolgend mit Hilfe eines Lasers getempert wird. Auch bei dieser Ausführungsform kann eine Beaufschlagung des gesamten Chips mit Temperatur zum Tempern der Kontaktstellen vorteilhafterweise vermieden werden.

Es sei an dieser Stelle darauf hingewiesen, dass die oben beschriebenen Verfahren zur Herstellung eines vorderseitigen Kontaktes unabhängig vom Herstellungsverfahren des restlichen Dünnfilmhalbleiterchips angewendet werden können.

Ein Dünnfilmleuchtdiodenchip zeichnet sich insbesondere durch folgende Merkmale aus:
- an einer zu einem Trägerelement hingewandten ersten Hauptfläche einer strahlungserzeugenden Epitaxieschichtenfolge ist eine reflektierende Schicht oder Schichtenfolge aufgebracht oder ausgebildet, die zumindest einen Teil der in der Epitaxieschichtenfolge erzeugten elektromagnetischen Strahlung in diese zurück reflektiert; und
- die Epitaxieschichtenfolge weist eine Dicke im Bereich von 20 µm oder weniger insbesondere im Bereich von 10 µm auf.

Vorzugsweise enthält die Epitaxieschichtenfolge mindestens eine Halbleiterschicht mit zumindest einer Fläche, die eine Durchmischungsstruktur aufweist, die im Idealfall zu einer annährend ergodischen Verteilung des Lichtes in der epitaktischen Epitaxieschichtenfolge führt, das heißt sie weist vorzugsweise ein möglichst ergodisch stochastisches Streuverhalten auf.

Ein Grundprinzip eines Dünnfilmleuchtdiodenchips ist beispielsweise in der Druckschrift I. Schnitzer at al., Appl. Phys. Lett. 63 (16), 18. Oktober 1993, 2174 - 2176, beschrieben.

In der Regel umfasst ein Dünnfilmleuchtdiodenchip im Bereich der Rückseite ein p-dotiertes III/V-Verbindungshalbleitermaterial und im Bereich der Vorderseite ein n-dotiertes III/V-Verbindungshalbleitermaterial. Eine umgekehrte Reihenfolge ist aber ebenso denkbar.

Umfasst die Seite der aktiven Schichtenfolge, auf die die Kontaktstelle aufgebracht wird, ein p-dotiertes Phosphid-III/V-Verbindungshalbleitermaterial, umfasst die Kontaktstelle bevorzugt mindestens eines der Element Au und Zn.

Vorzugsweise handelt es sich bei dem Phosphid-III/V-Verbindungshalbleitermaterial um AlₙGaₘIn₁₋ₙ₋ₘP, wobei 0 ≤ n ≤ 1, 0 ≤ m ≤ 1 und n+m ≤ 1, unabhängig von der Dotierung. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften eines des AlₙGaₘIn₁₋ₙ₋ₘP-Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Au stellt ein Material mit guten reflektiven Eigenschaften für elektromagnetische Strahlung mit Wellenlängen im roten Bereich des sichtbaren Lichtes dar. Zn diffundiert beim Tempern der Kontaktstelle in das p-dotierte Phosphid-III/V-Verbindungshalbleitermaterial und besetzt dort bevorzugt Gitterplätze des Gruppe-III-Übergitters unter Erzeugung von Löchern. Dadurch wird die Anzahl an Ladungsträger (Löcher) erhöht, was in der Regel zu einer verbesserten Charakteristik der elektrischen Kontaktstelle führt.

Umfasst die Seite der aktiven Schichtenfolge, auf die die Kontaktstelle aufgebracht wird, ein n-dotiertes Phosphid-III/V-Verbindungshalbleitermaterial, umfasst die Kontaktstelle bevorzugt mindestens eines der Elemente Au und Ge.

Auch in diesem Fall wird Au aufgrund seiner guten reflektierenden Eigenschaften bevorzugt als Material für die Kontaktstelle eingesetzt. Ge besetzt bevorzugt beim Tempern des Kontaktes ebenfalls Gitterplätze des Gruppe-III-Übergitters, trägt als Gruppe IV-Element jedoch ein Elektron mehr als die Atome des Gruppe-III-Übergitters und erhöht dadurch die Anzahl an Elektronen in diesem Bereich.

Umfasst die Seite der aktiven Schichtenfolge, auf die die Kontaktstelle aufgebracht wird, p-dotiertes Nitrid-III/V-Verbindungshalbleitermaterial, umfasst die Kontaktstelle bevorzugt mindestens eines der Elemente Pt, Rh, Ni, Au, Ru, Pd, Re und Ir.

Vorzugsweise handelt es sich bei dem Nitrid-III/V-Verbindungshalbleitermaterial um AlₙGaₘIn₁₋ₙ₋ₘN, wobei 0 ≤ n ≤ 1, 0 ≤ m ≤ 1 und n+m ≤ 1, unabhängig von der Dotierung. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften eines des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Umfasst die Seite der aktiven Schichtenfolge, auf die die Kontaktstelle aufgebracht wird, n-dotiertes Nitrid-III/V-Verbindungshalbleitermaterial, umfasst die Kontaktstelle bevorzugt mindestens eines der Elemente Ti, Al, und W.

Umfasst die Seite der aktiven Schichtenfolge, auf die die Kontaktstelle aufgebracht wird, ein Phosphid-III/V-Verbindungshalbleitermaterial, kann diese Seite weiterhin zusätzlich oder alternativ zu dem Phosphid-III/V-Verbindungshalbleitermaterial auch ein Arsenid-III/V-Verbindungshalbleitermaterial umfassen. Die Materialien, die abhängig von der Dotierung bevorzugt für die Kontaktstellen eingesetzt werden, weichen hierbei in der Regel nicht von den oben genannten ab.

Umfasst die Seite der aktiven Schichtenfolge, auf die die Kontaktstelle aufgebracht wird, ein Nitrid-III/V-Verbindungshalbleitermaterial, kann diese Seite ebenfalls weiterhin zusätzlich zu dem Nitrid-III/V-Verbindungshalbleitermaterial ein Arsenid-III/V-Verbindungshalbleitermaterial umfassen. Auch in diesem Fall weichen die Materialien, die abhängig von der Dotierung bevorzugt für die Kontaktstellen eingesetzt werden, in der Regel nicht von den oben genannten ab.

Vorzugsweise handelt es sich bei dem Arsenid-III/V-Verbindungshalbleitermaterial um AlₙGaₘIn₁₋ₙ₋ₘAS, wobei 0 ≤ n ≤ 1, 0 ≤ m ≤ 1 und n+m ≤ 1, unabhängig von der Dotierung. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften eines AlₙGaₘIn₁₋ₙ₋ₘAs-Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

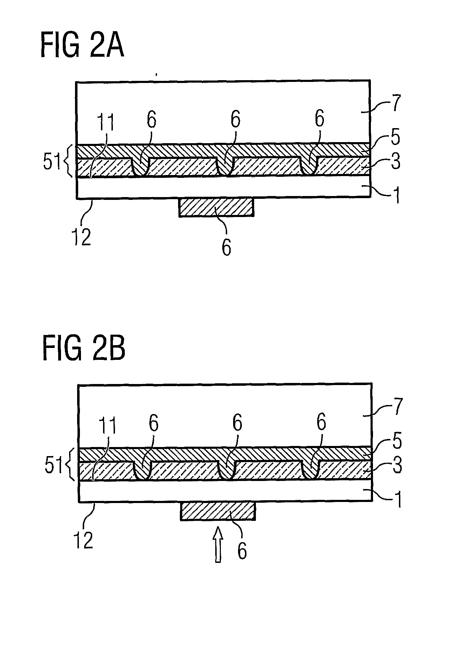

Weitere Vorteile und bevorzugte Ausführungsformen ergeben sich aus den nachfolgend in Verbindung mit den Figuren 1a bis 1f und 2a bis 2b beschriebenen zwei Ausführungsbeispielen.

Es zeigen:
Figuren 1a bis 1f, schematische Darstellungen verschiedener Verfahrensstadien eines ersten Ausführungsbeispiels gemäß eines der Verfahren, und
Figuren 2a bis 2b, schematische Darstellungen weiterer Verfahrensstadien des ersten Ausführungsbeispiels gemäß eines der Verfahrens

In den Ausführungsbeispielen und Figuren sind gleiche oder gleich wirkende Bestandteile jeweils mit den gleichen Bezugszeichen versehen. Die dargestellten Elemente der Figuren, insbesondere Dicken von Schichten sind grundsätzlich nicht als maßstabsgetreu anzusehen, vielmehr können sie zum besseren Verständnis teilweise übertrieben groß dargestellt sein.

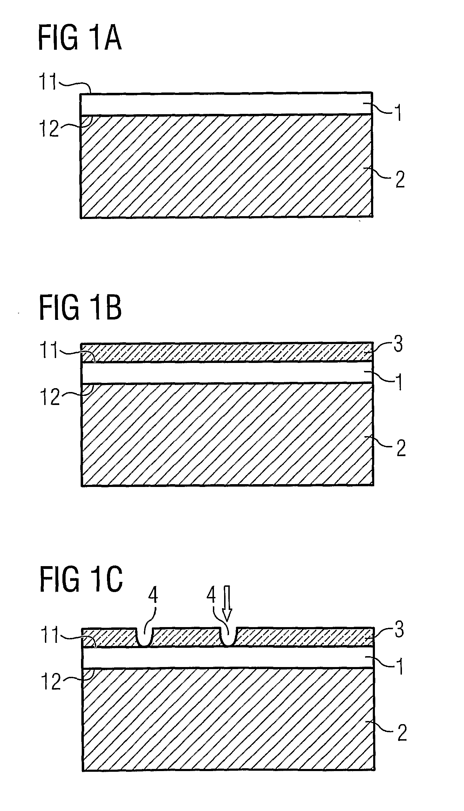

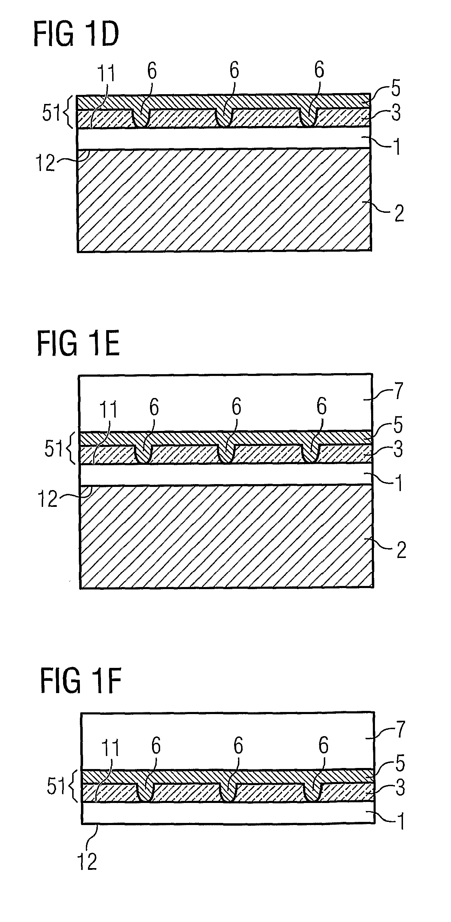

Bei dem Ausführungsbeispiel gemäß den Figuren 1a bis 1f wird zur Herstellung eines Dünnfilm-LED-Chips eine aktive Schichtenfolge 1 basierend auf einem III/V-Verbindungshalbleitermaterial epitaktisch auf ein Aufwachssubstrat 2 aufgebracht. Die Seite der aktiven Schichtenfolge 1, die zu dem Aufwachssubstrat 2 hinweist, wird als Vorderseite 12 bezeichnet und die Seite der aktiven Schichtenfolge 1, die der Vorderseite 12 gegenüberliegt, als Rückseite 11. Die aktive Schichtenfolge 1 ist geeignet elektromagnetische Strahlung zu emittieren und weist beispielsweise einen strahlungserzeugenden pn-Übergang oder eine strahlungserzeugende Einfach- oder Mehrfachquantentopfstruktur auf. Solche Strukturen sind dem Fachmann bekannt und werden daher nicht näher erläutert. Die aktive Schichtenfolge 1 umfasst beispielsweise AlGaInP oder GaInN, wobei die Vorderseite 12 der aktiven Schichtenfolge 1 n-dotiert und die Rückseite 11 p-dotiert ist. Soll eine aktive Schichtenfolge 1 basierend auf einem Nitrid-III/V-Verbindungshalbleitermaterial epitaktisch aufgewachsen werden, kann als Material für das Aufwachssubstrat 2 beispielsweise GaN, SiC oder Saphir verwendet werden. Ein geeignetes Aufwachssubstrat 2 für das epitaktische Wachstum einer aktiven Schichtenfolge 1 basierend auf einem Phosphid-III/V-Verbindungshalbleiter umfasst beispielsweise GaAs.

Nachfolgend auf die aktive Schichtenfolge 1 wird eine dielektrische Schicht 3 aufgebracht, die beispielsweise SiNₓ umfasst. In der dielektrischen Schicht 3 werden mit Hilfe eines Lasers punktförmige Öffnungen 4 erzeugt, so dass die Rückseite 11 der aktiven Schichtenfolge 1 innerhalb dieser Öffnungen 4 frei liegt. Diese Öffnungen 4 weisen in der Regel einen Durchmesser von 1 µm bis 20 µm, so dass bei den nachfolgenden Prozessschritten eine Kontaktstelle 6 mit einem Durchmesser dieser Größe entsteht.

In einem weiteren Schritt wird eine metallische Schicht 5 nachfolgend auf die dielektrische Schicht 3 beispielsweise durch Aufdampfen oder Sputtern aufgebracht. Die dielektrische Schicht 3 und die metallische Schicht 5 bilden zusammen eine reflektierende Schichtenfolge 51. Für den Fall, dass die Rückseite 11 der aktiven Schichtenfolge 1 ein p-dotiertes Phosphid-III/V-Verbindungshalbleitermaterial umfasst, wie beispielsweise AlGaInP, enthält die metallische Schicht 5 bevorzugt Gold und Zn. Umfasst die Rückseite 11 der aktiven Schichtenfolge 1 hingegen beispielsweise ein p-dotiertes Nitrid-III/V-Verbindungshalbleiter, wie beispielsweise GaInN, enthält die metallische Schicht 5 bevorzugt Pt, Rh, Ni, Au, Ru, Pd, Re oder Ir.

Beim Aufbringen des metallischen Materials werden die Öffnungen 4 gefüllt und untereinander mit metallischem Material verbunden, so dass elektrisch leitfähige Kontaktstellen 6 zur Rückseite 11 der aktiven Schichtenfolge 1 ausgebildet werden, die untereinander elektrisch leitfähig verbunden sind.

Um eine Kontaktstelle 6 mit einer weitestgehend ohmschen Charakteristik zu erhalten, wird die Kontaktstelle 6 anschließend getempert. Hierzu kann beispielsweise der ganze Chip in einen Ofen eingebracht werden, der den Chip einer Umgebungstemperatur von 450 °C aussetzt. Bevorzugt werden die Kontaktstellen 6 jedoch lokal mit einem Laser getempert. Das Tempern von elektrischen Kontaktstellen 6 mit Hilfe eines Lasers ist in der Druckschrift DE 101413521 beschrieben, deren Offenbarungsgehalt insofern hiermit durch Rückbezug aufgenommen wird.

Sollen die rück- oder vorderseitigen Kontaktstellen 6 unterschiedliche metallische Materialien enthalten, können auch mehrere Schichten aufgebracht werden, die die jeweiligen metallischen Materialen enthalten. Bevorzugt sind die Schichtdicken in diesem Fall sehr dünn. Nach der rückseitigen elektrischen Kontaktierung der aktiven Schichtenfolge 1 wird auf die metallische Schicht 5 ein Träger 7 beispielsweise durch Löten oder Kleben aufgebracht. In einem nachfolgenden Schritt wird das Aufwachssubstrat 2 entfernt.

Zur vorderseitigen elektrischen Kontaktierung der aktiven Schichtenfolge 1 wird auf die Vorderseiten 12 der aktiven Schichtenfolge 1 ebenfalls eine elektrische leitfähige Kontaktstelle 6 aus einem metallischen Material aufgebracht. Enthält die Vorderseite 12 der aktiven Schichtenfolge 1 ein n-dotiertes Phosphid-III/V-Verbindungshalbleitermaterial, wie beispielsweise AlGaInP, enthält das metallische Material im Wesentlichen Au und Ge. Für den Fall, dass die Vorderseite 12 ein n-dotiertes Nitrid-III/V-Verbindungshalbleiter enthält, wie beispielsweise GaInN, enthält das metallische Material bevorzugt Ti, Al oder W. Wie die rückseitige Kontaktstelle 6 wird auch die vorderseitige Kontaktstelle 6 getempert, ebenfalls besonders bevorzugt mit einem Laser.

## Patentansprüche

1. Verfahren zur Herstellung eines DünnfilmHalbleiterchips basierend auf einem III/V-Verbindungshalbleitermaterial, der geeignet ist elektromagnetische Strahlung zu erzeugen, mit den Schritten:
- Aufbringen einer aktiven Schichtenfolge (1), die geeignet ist, elektromagnetische Strahlung zu erzeugen, auf einem Aufwachssubstrat (2), mit einer zum Aufwachssubstrat (2) hingewandten Vorderseite (12) und einer vom Aufwachssubstrat (2) abgewandten Rückseite (11),
- Aufbringen mindestens einer dielektrischen Schicht (3) als Teil einer reflektierenden Schichtenfolge (51) auf die Rückseite (11) der aktiven Schichtenfolge (1), wobei die dielektrische Schicht (3) eine Phosphosilikatglasschicht aufweist, die mit einer Verkapselungsschicht gekapselt wird, die Siliziumnitrid aufweist,
- Einbringen von Energie mit Hilfe eines Lasers in definiert begrenzte Volumenbereiche (8) der dielektrischen Schicht (3), so dass in dieser mindestens eine Öffnung (4) zur Rückseite (11) der aktiven Schichtenfolge (1) hin ausgebildet wird,
- Aufbringen mindestens einer metallischen Schicht (5) als weiteren Teil der reflektierenden Schichtenfolge (51) auf die der aktiven Schichtenfolge (1) abgewandte Seite der dielektrischen Schicht (3), so dass beim Aufbringen der metallischen Schicht (5) die Öffnung (4) mit metallischem Material zumindest teilweise gefüllt wird und mindestens eine rückseitige elektrisch leitfähige Kontaktstelle (6) zur Rückseite (11) der aktiven Schichtenfolge (1) ausgebildet wird,
- Anbringen eines Trägers (7) auf der reflektierenden Schichtenfolge (51) und
- Entfernen des Aufwachssubstrates (2).

2. Verfahren nach Anspruch 1, bei dem die rückseitige Kontaktstelle (6) getempert wird.

3. Verfahren nach Anspruch 2, bei dem
die rückseitige Kontaktstelle (6) mit Hilfe eines Laser getempert wird.

4. Verfahren nach einem der Ansprüche 1 bis 3, bei dem
- auf der Vorderseite (12) der aktiven Schichtenfolge (1) eine vergütende Schichtenfolge (52) aufgebracht wird, die mindestens eine dielektrische Schicht (3) umfasst,
- zumindest teilweise mindestens eine metallische Schicht (5) auf die vergütende Schichtenfolge (52) aufgebracht wird und
- Energie mit Hilfe eines Lasers in lateral definiert begrenzte Volumenbereiche (8) der vergütenden Schichtenfolge (52) und der metallischen Schicht (5) eingebracht wird, so dass mindestens eine vorderseitige elektrisch leitfähige Kontaktstelle (6) zur Vorderseite (12) der aktiven Schichtenfolge (1) ausgebildet wird.

5. Verfahren nach einem der Ansprüche 1 bis 3, bei dem
- auf der Vorderseite (12) der aktiven Schichtenfolge (1) mindestens eine vorderseitige elektrisch leitfähige Kontaktstelle (6) aufgebracht wird und
- die vorderseitige elektrisch leitfähige Kontaktstelle (6) mit Hilfe eines Lasers getempert wird.

6. Verfahren nach einem der obigen Ansprüche, bei dem
- die Seite (11, 12) der aktiven Schichtenfolge (1), auf die die Kontaktstelle (6) aufgebracht wird, ein p-dotiertes Phosphid-III/V-Verbindungshalbleitermaterial und/oder ein p-dotiertes Arsenid-III/V-Verbindungshalbleitermaterial umfasst und
- die Kontaktstelle (6) mindestens eines der Elemente Au und Zn umfasst.

7. Verfahren nach einem der obigen Ansprüche, bei dem
- die Seite (11, 12) der aktiven Schichtenfolge (1), auf die die Kontaktstelle (6) aufgebracht wird, ein n-dotiertes Phosphid-III/V-Verbindungshalbleitermaterial und/oder ein n-dotiertes Arsenid-III/V-Verbindungshalbleitermaterial umfasst und
- die Kontaktstelle (6) mindestens eines der Elemente Au und Ge umfasst.

8. Verfahren nach einem der obigen Ansprüche, bei dem
- die Seite (11, 12) der aktiven Schichtenfolge (1), auf die die Kontaktstelle (6) aufgebracht wird, ein p-dotiertes Nitrid-III/V-Verbindungshalbleitermaterial umfasst und
- die Kontaktstelle (6) mindestens eines der Elemente Pt, Rh, Ni, Au, Ru, Pd, Re und Ir umfasst.

9. Verfahren nach einem der obigen Ansprüche, bei dem
- die Seite (11, 12) der aktiven Schichtenfolge (1), auf die die Kontaktstelle (6) aufgebracht wird, ein n-dotiertes Nitrid-III/V-Verbindungshalbleitermaterial umfasst und
- die Kontaktstelle (6) mindestens eines der Element Ti, Al, und W umfasst.

10. Dünnfilm-Halbleiterchip, der nach einem Verfahren gemäß einem der obigen Ansprüche hergestellt wurde.

## Claims

1. Method for producing a thin-film semiconductor chip based on a III/V compound semiconductor material, said chip being suitable for generating electromagnetic radiation, comprising the following steps:
- applying an active layer sequence (1), suitable for generating electromagnetic radiation, on a growth substrate (2), having a front side (12) facing towards the growth substrate (2) and a rear side (11) facing away from the growth substrate (2),
- applying at least one dielectric layer (3) as part of a reflective layer sequence (51) to the rear side (11) of the active layer sequence (1) wherein the dielectric layer (3) comprises a phosphosilicate glass layer encapsulated with an encapsulation layer comprising silicon nitride,
- introducing energy with the aid of a laser into volume regions (8) of the dielectric layer (3) that are delimited in a defined manner, such that at least one opening (4) towards the rear side (11) of the active layer sequence (1) is formed in said dielectric layer,
- applying at least one metallic layer (5) as a further part of the reflective layer sequence (51) to that side of the dielectric layer (3) which faces away from the active layer sequence (1), such that during the process of applying the metallic layer (5) the opening (4) is at least partially filled with metallic material and at least one rear-side electrically conductive contact location (6) to the rear side (11) of the active layer sequence (1) is formed, and
- fitting a carrier (7) on the reflective layer sequence (51) and
- removing the growth substrate (2).

2. Method according to Claim 1, wherein the rear-side contact location (6) is heat-treated.

3. Method according to Claim 2, wherein the rear-side contact location (6) is heat-treated with the aid of a laser.

4. Method according to any of Claims 1 to 3, wherein
- an antireflective layer sequence (52) comprising at least one dielectric layer (3) is applied on the front side (12) of the active layer sequence (1),
- at least one metallic layer (5) is at least partially applied to the antireflective layer sequence (52), and
- energy is introduced with the aid of a laser into volume regions (8) of the antireflective layer sequence (52) and of the metallic layer (5) that are delimited in a laterally defined fashion, such that at least one front-side electrically conductive contact location (6) to the front side (12) of the active layer sequence (1) is formed.

5. Method according to any of Claims 1 to 3, wherein
- at least one front-side electrically conductive contact location (6) is applied on the front side (12) of the active layer sequence (1), and
- the front-side electrically conductive contact location (6) is heat-treated with the aid of a laser.

6. Method according to any of the preceding claims, wherein
- the side (11, 12) of the active layer sequence (1) to which the contact location (6) is applied comprises a p-doped phosphide III/V compound semiconductor material and/or a p-doped arsenide III/V compound semiconductor material, and
- the contact location (6) comprises at least one of the elements Au and Zn.

7. Method according to any of the preceding claims, wherein
- the side (11, 12) of the active layer sequence (1) to which the contact location (6) is applied comprises an n-doped phosphide III/V compound semiconductor material and/or an n-doped arsenide III/V compound semiconductor material, and
- the contact location (6) comprises at least one of the elements Au and Ge.

8. Method according to any of the preceding claims, wherein
- the side (11, 12) of the active layer sequence (1) to which the contact location (6) is applied comprises a p-doped nitride III/V compound semiconductor material, and
- the contact location (6) comprises at least one of the elements Pt, Rh, Ni, Au, Ru, Pd, Re and Ir.

9. Method according to any of the preceding claims, wherein
- the side (11, 12) of the active layer sequence (1) to which the contact location (6) is applied comprises an n-doped nitride III/V compound semiconductor material and
- the contact location (6) comprises at least one of the elements Ti, Al and W.

10. Thin-film semiconductor chip which was produced according to a method according to any of the preceding claims.

## Revendications

1. Procédé de fabrication d'une puce semi-conductrice à couche mince base sur un matériau semi-conducteur de liaison III/V, qui est approprié pour générer un rayonnement électromagnétique, avec les étapes consistant à :
- appliquer une succession de couches active (1), qui est approprié pour générer un rayonnement électromagnétique sur un substrat de croissance (2), avec un côté avant (12) tourné vers le substrat de croissance (2) et un côté arrière (11) qui se détourne du substrat de croissance (2),
- appliquer au moins une couche diélectrique (3) comme partie d'une succession de couches réfléchissantes (51) sur le côté arrière (11) de la succession de couches active (1),
- dans lequel la couche diélectrique (3) présente une couche de verre de phosphosilicate, qui est encapsulée avec une couche d'encapsulation, qui présente du nitrure de silicium,
- appliquer et de l'énergie avec un laser dans des zones de volume délimité défini (8) de la couche diélectrique (3), de telle sorte que dans cette dernière un au moins une ouverture (4) allant vers le côté arrière (11) de la succession de couches active (1) soit réalisée,
- appliquer au moins une couche métallique (5) comme partie supplémentaire de la succession de couches réfléchissantes (51) sur le côté de la couche diélectrique (3) qui se détourne de la succession de couche active (1), de sorte que lors de l'application de la couche métallique (5) l'ouverture (4) soit remplie au moins partiellement avec du matériau métallique et au moins un point de contact conducteur électriquement du côté arrière (6) soit réalisé par rapport au côté arrière (11) de la succession de couche active (1),
- appliquer un support (7) sur la succession de couches réfléchissantes (51) et
- retirer le substrat de croissance (2).

2. Procédé selon la revendication 1, dans lequel le point de contact du côté arrière (6) est recuit.

3. Procédé selon la revendication 2, dans lequel le point de contact du côté arrière (6) est recuit à l'aide d'un laser.

4. Procédé selon une des revendications 1 à 3, dans lequel
- sur le côté avant (12) de la succession de couche active (1) une succession de couches soumise à un traitement thermique (52) est appliquée, qui comprend au moins une couche diélectrique (3),
- au moins partiellement au moins une couche métallique (5) est appliquée sur la succession de couches soumise à un traitement thermique (52), et
- de l'énergie est appliquée à l'aide d'un laser dans des zones de volume délimité défini (8) latéral de la succession de couches soumises à un traitement thermique (52) et de la couche métallique (5), de sorte qu'au moins un point de contact électriquement conducteur du côté avant (6) soit réalisé par rapport au côté avant (12) de la succession de couches active (1).

5. Procédé selon une des revendications 1 à 3, dans lequel
- sur le côté avant (12) de la succession de couches active (1) au moins un point de contact électriquement conducteur du côté avant (6) est appliqué et
- le point de contact électriquement conducteur du côté avant (6) est recuit à l'aide d'un laser.

6. Procédé selon une des revendications ci-dessus, dans lequel
- le côté (11,12) de la succession de couches active (1), sur lequel le point de contact (6) est appliqué, comprend un matériau semi-conducteur de liaison phosphure p-dopé III/V et/ou un matériau semi-conducteur de liaison arséniure p-dopé III/V et
- le point de contact (6) comprend au moins un des éléments Au et Zn.

7. Procédé selon une des revendications six dessus, dans lequel
- le côté (11,12) de la succession de couches active (1), sur lequel le point de contact (6) est appliqué, comprend un matériau semi-conducteur de liaison phosphure n-dopé III/V et/ou un matériau semi-conducteur de liaison arséniure n-dopé III/V et
- le point de contact (6) comprend au moins un des éléments Au et Ge.

8. Procédé selon une des revendications ci-dessus, dans lequel
- le côté (11,12) de la succession de couches active (1), sur lequel le point de contact (6) est appliqué, comprend un matériau semi-conducteur de liaison nitrure p-dopé III/V et
- le point de contact (6) comprend au moins un des éléments Pt, Rh, Ni, Au, Ru, Pd, Re et Ir.

9. Procédé selon une des revendications ci-dessus dans lequel
- le côté (11,12) de la succession de couches active (1), sur lequel le point de contact (6) est appliqué, comprend un matériau semi-conducteur de liaison nitrure n-dopé III/V et
- le point de contact (6) comprend au moins un des éléments Ti, Al et W.

10. Puce semi- conductrice à couche mince, qui est fabriquée conformément à un procédé selon une des revendications ci-dessus.
